# EUROPEAN PATENT SPECIFICATION

(11) **EP 2 417 635 B1**
(45) Date of publication and mention of the grant of the patent: **28.11.2012**
(21) Application number: 10713445.4
(22) Date of filing: 08.04.2010
(51) Int. Cl.: H01L 31/0236, H01L 31/0232, B29C 45/34

(54) **Method for producing a cover plate for a photovoltaic device**
Verfahren zur Herstellung einer Abdeckplatte für eine Photovoltaikanordnung
Procédé de production d'une plaque de protection pour dispositif photovoltaïque

(30) Priority: 08.04.2009 EP 09157630; 05.06.2009 EP 09162038
(43) Date of publication of application: 15.02.2012
(73) Proprietor: Solarexcel B.V., 5803 AN Venray (NL)
(72) Inventor: SLAGER, Ben, NL-3911 RW Rhenen (NL)
(74) Representative: Oberlein, Gerriet H. R.
(86) International application number: PCT/EP2010/054640
(87) International publication number: WO 2010/115954

(56) References cited:
- WO-A-2009/059998
- JP-A- 2005 150 242
- US-A- 5 709 922
- US-A- 6 075 652
- US-A1- 2002 084 545
- US-A1- 2004 026 832

## Description

The invention pertains to a method for producing a relief textured cover plate for a photovoltaic device.

This method is based on a resin, which is liquid at room temperature, and hardening said resin into a relief textured cover plate when said resin is in contact with a mold. The resulting relief textured cover plate can be used directly as a cover plate for a photovoltaic device or is applied to one of the surfaces of a transparent substrate by using an appropriate adhesive. The transparent substrate containing one or more relief textured cover plates can be used as or on top of a cover plate for a photovoltaic device.

Solar cells (photovoltaic cells or photovoltaic devices) are commonly used to convert light energy into electrical energy. This effect is known as the photovoltaic effect. Solar cells contain an active layer which consists of a light absorbing material which generates charge carriers upon light exposure. An active layer which is commonly used in photovoltaic devices is silicon. However, a variety of materials can be encountered like for example gallium arsenide (GaAs), cadmium telluride (CdTe) or copper indium gallium diselenide (CIGS). The charges, which are generated in the active layer, are separated to conductive contacts that transmit electricity. Due to the thin and brittle nature of the active layer it is usually protected from external influences by a transparent cover plate (commonly glass). This cover plate is positioned between the light source and the light receiving side of the active layer. Most of the time, a single solar cell cannot produce enough electricity for the desired purpose and the cells are therefore linked together to form a larger type of photovoltaic device. Assemblies of cells are used to make solar modules, which in turn may be linked into photovoltaic arrays. Individual cells can be used to power small devices such as calculators or electronic watches. Modules or photovoltaic arrays are for example encountered on the roof tops of houses or off-grid applications such as boats, traffic signs or spacecrafts.

It is known from the prior art that the active layer, the cover plate and other components reflect a part of the light incident to the photovoltaic device. Especially the high refractive index of the active layer causes large reflection losses which can, in the case of silicon, be over 30% of the incident light. Since the reflected light cannot be converted into electrical energy these reflection losses cause a large reduction in the efficiency of a photovoltaic device.

It is known from the prior art that the reflection losses of a photovoltaic device can be reduced by applying a relief texture to the cover plate. The relief texture reduces the reflection losses of the cover plate (which is known as "antireflection") and of the component protected by the cover plate such as the active layer or electrodes. The latter effect is often referred to as "trapping". The size of said relief textures are always in the millimetre range since sufficient strength is required to ensure long-term outdoor durability. Smaller structures would be more susceptible to damaging while larger structures would require too much material and thus result in high product costs. Different relief textures can be used such as for example an array of pyramidal textures (WO03/046617), V-shaped grooves (G.A. Landis, 21st IEEE photovoltaic specialist conference, 1304-1307 (1990)), round pits (P. Sánchez-Friera, IEEE 4th World Conference on photovoltaic energy conversion, 2156 - 2159 (2006)), or structures consisting of a base and an apex which are connected by n-polygonal surfaces with n being equal to 4 or higher (W02009059998) are applied to a cover plate to reduce the reflection losses of said plate and increase the transmission of light.

A model study shows that a pyramidal relief textured cover plate can increase the efficiency of the photovoltaic device by up to 6% (U. Blieske et all, 3rd World Conference on Photovoltaic Energy Conversion, 188-191 (2003)). In practice the results are however less than 6% and usually only an improvement of 3% is obtained. This low performance can be attributed to the manufacturing process. The relief textures are commonly applied to the glass or polymeric cover plate via hot rolling (W02005111670, WO03/046617). This is a typical technique for creating millimetre sized structures in a fast production process. With this technique the material to be textured is softened by heating. The softened material is textured by mechanical contact with hard (usually metal) mould. To fix the texture, the material is cooled to room temperature at which it hardens. The problem arises from that both polymers and glasses have the tendency to deform back to their untextured flat shape. This relaxation is caused by the viscoelastic behaviour of polymers and glasses. As a result the shape of the relief texture in the cover plate is deformed from its ideal shape. The performance increase of photovoltaic devices by the imperfectly textured cover plate is of course lower than from a perfectly textured cover plate. Furthermore, this processing technique requires relatively high temperatures to soften the material to be textured. To ensure uniform heating both the material and the mold are heated. For most polymers a temperature around 150 degrees Celsius and for most glasses a temperature around 1000 degrees Celsius is required. The heating and subsequent cooling of the material is extremely energy consuming. The heating/cooling cycle should also be done very carefully to avoid damaging, deforming or breaking of the cover plates. Another disadvantage of the current processing techniques is that relatively high pressures are required to ensure that the geometry of the relief texture is as optimal as possible. The high pressures cause significant wear of the mold.

Alternatively it is possible to use the technique of casting (W02009059998). Casting is a manufacturing process by which a liquid material is usually poured into a mold, which contains a hollow cavity of the desired shape, and then allowed to solidify. Casting materials are usually metals or various cold setting materials that cure after mixing two or more components together; examples are epoxy, concrete, plaster and clay. Casting involves a resin which is liquid at room temperature. This resin is poured into a mould and subsequently cured into a solid product via a thermally initiated reaction. This process is slow due to the absence of pressure during filling of the mould. Additionally, also air entrapments will occur in the resin at the textured interface between the mould and the resin. The absence of a pressure during hardening of the liquefied material in the casting process upon cooling results in deformation due to thermal shrinkage.

Another casting proces is resin casting. Resin casting is a method of plastic casting where a mold is filled with a liquid synthetic resin which then hardens. Most commonly a thermoserring resin is used that polymerizes by mixing with a curing agent at room temperature and normal pressure. The synthetic resins used include polyurethane resin, epoxy resin, unsaturated polyester resin and silicone resin. As already described the absence of a presure during the harderning results in a deformation and a thermal shrinkage.

One might also consider the conventional techniques used in the manufacturing of submicrometer structures for creating larger structures. For example, in one particular case the process of laminating is used to create a submicrometer sized relief texture into a polymeric cover plate for a photovoltaic device (US6075652). The relief texture, which due to its size has a purely anti-reflective function (and thus not trapping), is created by placing a sheet of ethylenevinylacetate (EVA) in contact with mould and placing this assembly into a laminator. The disadvantage of this method is similar to the once discussed previously for hot-rolling. Also here a solid polymeric material, although referred to as a resin, is liquefied by heat. The heating and subsequent cooling of the material is extremely energy and time consuming. These disadvantages become even more obvious when considering the desired millimetre sized structures used for trapping and antireflection. The size of these structures would require the use of thick sheets of EVA (in the millimetre range) which requires even more energy and time to process. Also thermal deformation of the product become a significant issue.

Other methods for creating small structures are for example mentioned in DE 100 01 135. Here surface textures are created within the range of µm to nm. Contact less hardening is a main point in the method described in DE 100 01 135. In WO 2008/145176 a method for producing micro-lenses is described. In this method a thermoplastic polymer is hot embossed with a stamp. By the method disclosed in the prior art documents it is possible to create very small structures in the range of µm. Structures, larger than micro lenses cannot be produced by this method. None of the these processing techniques is suitable for creating millimeter sized structures with micrometer precision over large surfaces. This precision is required to ensure the performance of the device. The main problems are deformation of relief structures if made of millimetre size or deformation of the devices themselves. It is known from the prior art that it is possible to create micrometer structures with micrometer precision over large surfaces. Yet, millimeter sized structures over large surface with high accuracy is extremely difficult.

In addition the cover plates of photovoltaic devices are often given surface properties such as scratch resistance or hardness. Due to the manufacturing techniques used in prior art it is not possible to improve the surface properties without treating the complete cover plate. As a result expensive techniques have to be applied to the complete device rather than the top layer to which it is relevant. For example, in the case of polymers it is possible to improve the scratch resistance by adding expensive anorganic nanoparticles to the polymer matrix material. A thin layer of nanoparticles near the air/polymer interface would be sufficient. However, when using the production methods of the prior art (i.e hot-rolling) it is far more simple to disperse these nano-particles homogenously throughout the cover plate. To avoid this problem it is possible to texture a polymeric sheet and next apply this sheet to a glass or polymeric cover plate by using adhesives. Although this solves this specific problem, it still requires relatively high temperatures and high pressure to texture the polymeric sheet.

It is the objective of the current invention to overcome the problems of the prior art.

These problems can be overcome by a method for producing a cover plate for a photovoltaic device according to claim 1.

The cover plate can also be referred to as a surface relief textured cover sheet or as a textured plate.

The use of a resin which is liquid at room temperature obviates the use of high temperatures for liquification. This allows accurate filling of the mould and allows the use of low mould temperatures. Materials which require temperature for maintaining a liquid state would solidify in a low temperature mould and thus create problems. Additionally a high mould temperature would induce severe thermal shrinkage issues such as warpage or deformation of the final product. Furthermore, the use of a resin which is liquid at room temperature requires less energy and low pressures can be used to press the mould containing the inverse texture of the desired relief into the resin (or the press the resin in the mould). This results in less wear of the mould. Evacuating the air from the mould avoids air entrapment. In addition, this pressure difference, can increase the rate of filling the mould with resin. Additional pressure might be used to further enhance the filling rate and to reduce air entrapment even further.

By using the method according to the invention, a cover plate can be obtained of superior quality and performance compared to the known methods. The relief on the obtained cover plate is an accurate negative copy of the relief inside the mold. A plate manufactured according to the method described in this invention can increase the performance of the photovoltaic device.

In a preferred embodiment the surface relief texture is made of structures, whereby each structure has a height between 0.5 to 10mm, more preferably between 0.75 to 5 mm and most preferably between 0.95 to 4 mm.

The textured plate can exhibit a groove, pyramid, cone and/or hemisphere structure and/or structures known from published application WO 2009/059998, whereby the published application is filed in the name of the applicant and inserted herewith as reference in its entirety. The surface texture of the cover plate can exhibits any structure in relief at the surface of a plate. The texture can consist of a single kind of structure or a plurality of varied structures. The structures can be positioned in an ordered array or a random orientation. The texture (this means the surface texture) can positioned on one or more of the surfaces of the plate and preferably the texture is positioned on the surface of the cover plate which faces away from the active layer of the photovoltaic device. When describing the projected area of a structure by a circle wherein at least one of the edges of the projected area lie on the circumferential line of the circle, the diameter D of the circle is preferably less than 30 mm, more preferably less than 10 mm and most preferably less than 3 mm.

In the following the structure is specified, whereby the specification is applied to a single structure. Certainly the specification is also applied to a plurality of structures. Preferably, the structure contains three square (this means n polygonal) surfaces (n=4) which directly connect a hexagonal base to a single apex and the structure contains 9 surfaces in total. It is also possible that the structure exhibits partially rounded surfaces. A rounded, curved or partially curved surface is an n-polygonal surface where n is infinite.

It is also preferred when the structure comprises a m-polygonal base and an apex area. Said m-polygonal base and said apex area are connected by m surfaces with m being equal to 3 or higher. The structure is preferably further characterized in that at most two of the m surfaces, which connect the apex to the base should be n-polygonal shaped with n being equal to four or higher. The apex area is defined as the upper part of an individual geometrical optical structure to which the surfaces which are connected to the base combine. The apex area can be a point (e.g. as encountered in a pyramid or cone) or a line (e.g. as encountered in a groove). The apex area may also be a small surface which is parallel to the m-polygonal base of the individual geometrical optical structure. Examples of such a single structure of the array of geometrical optical structures are cylinders with a circular cross section or cupola shaped structures. Examples of a single structure of the array of geometrical optical structures are pyramids with a triangular base, pyramids with a rectangular base, cones, v-shaped grooves, tilted V-grooves or a sawtooth profile.

In a preferred embodiment of the invention m is extremely large and be considered as being equal to infinite. In this particular case an individual geometrical optical structure of the array exhibits an at least partially rounded cross section. Such a geometrical optical structure may be in the shape of a cone.

In one preferred embodiment of the invention the surface relief textured cover plate mentioned in WO2009059998 should be produced such that the orientation of a single relief texture is characterized in that one of the three n-polygonal surfaces of which the single relief texture comprises is parallel to one of the outer edges of the surface relief textured plate. Preferably the n-polygonal surface should be positioned parallel to the lower or upper outer edge of the relief textured plate. Orienting the relief texture has advantages for processing and self-cleaning properties. This effect is already described in US2007240754A1 for pyramid shaped structures. Surprisingly for pyramid shaped structures the effect is however achieved by placing the triangular surfaces of which the pyramid comprises not parallel to one of outer edges of the surface relief textured plate.

The texture of the textured plate can be any structure in relief. The texture can consist of a single kind of structure or a plurality of varied structures. The structures can be positioned in an ordered array or a random orientation. The texture can positioned on one or more of the surfaces of the plate and preferably the texture is positioned on the surface of a cover plate which faces away from the active layer of the photovoltaic device. When describing the projected area of a structure by a circle wherein at least one of the edges of the projected area lie on the circumferential line of the circle, the diameter D of the circle is preferably less than 30 mm, more preferably less than 10 mm and most preferably less than 3 mm.

In the current invention a surface relief textured cover sheet for a photovoltaic device is created by using a resin, which is liquid at room temperature, and hardening said resin into a textured plate when said resin is in contact with a mold. The resulting textured cover plate can be used directly as a cover plate for photovoltaic device or is applied to one of the surfaces of a transparent substrate by using an appropriate adhesive. The transparent substrate may contain one surface relief textured cover plate, but preferably more than one and most preferably more than two plates. In one preferred embodiment the transparent substrate contains a plurality of the same shaped textured plates. In another preferred embodiment the transparent substrate contains a plurality of different shaped textured plates. The transparent substrate containing one or more textured cover plates can be used as or on top of a further cover plate for a photovoltaic device. For example: a textured polymeric cover plate is applied to the glass front cover of a solar panel via laminating using ethylenevinylacetate (EVA). In this example EVA is used as an appropriate adhesive. In principle any adhesive can be used as long as the refractive index is between 1.3 and 1.7 such that optical contact between the textured plate and the transparent substrate is obtained. The adhesive may comprise of a monomer, polymer, initiator, catalyst or any combination thereof.

A cover plate for a photovoltaic device is any plate which can be used in combination with photovoltaic device. Preferably said plate is positioned in front of the light receiving side of the photovoltaic device and most preferably in direct optical contact (i.e. no air gap) with the light receiving side of the active layer in the photovoltaic device.

The textured plate can be any size, but preferably its lateral dimensions (x,y) are significantly large than its axial dimensions (z).

In a preferred embodiment the relief texture (this means the structures) of the textured plate is covered with an additional coating with a different refraction index than the material in which the relief structures are created. The shape of the coating is complementary to the structures such that the surface of the coating which is not in contact with structures, can be considered as flat. For example, it is possible to create a textured plate with structures in a high refractive index material and coat it with a low refractive index material such that there is no relief texture after coating. In other words, the high refractive relief structures are "filled" with low refractive index material. In another embodiment the obtained textured plate is coated with an additional thin layer after hardening the textured plate. Such a coating can for example be an anti-reflection coatings, anti-scratch coating, anti-fouling coating or protective coating. The additional thin layer can also be applied into the mould prior to filling the mould with resin. This way a perfect copy of the texture into the resin/thin layer system is obtained.

The method according to the invention is characterized by the use of a resin which is liquid at room temperature. Room temperature is considered to be 20°C. A resin may consist of a single component or preferably a mixture of components. Said components are for example, monomers, oligomers, photoinitiators, inorganic (e.g. SiO₂ or TiO₂) nanoparticles, dyes, UV absorbers, HALS stabilizers, polymers, wetting agents, plasticizers, optical brighteners, inhibitors and/or anti oxidants.

Preferably, the resin for producing the textured plate is a mixture of monomer(s) and/or oligomer(s). Preferably the resin mainly consists of polymer precursors. This can be either monomers or oligomers. After hardening they form a polymeric material.

Preferably, the resin for producing the textured plate comprises photoinitiator and/or at least one additive.

The resin needs to be liquid at room temperature. The viscosity of the resin is important for processing. Preferably a resin with a viscosity at room temperature between 500 - 5000 Pa - s is used. More preferred a resin with a viscosity at room temperature between 600 to 3000 Pa - s is used. Most preferred a resin with a viscosity at room temperature between 700 to 2000 Pa - s is used. Although the resin should be liquid at room temperature, it is possible that the heat is used during processing. Heating of the resin reduces its viscosity, which in turn reduces the filling time of the mould and helps to avoid air entrapment.

The resin can be hardened into a polymeric material by self-curing (e.g. a multiple component system), thermal treatment and/or electromagnetic radiation. Preferably, the resin is hardened by electromagnetic radiation.

The electromagnetic radiation used for hardening the resin can be for example be radio waves, microwaves, terahertz radiation, infrared radiation, visible radiation, x-rays or gamma rays. The electromagnetic radiation is preferably UV light with a wavelength between the range of 200-400nm. Also techniques which emit a small amount of electromagnetic radiation beside other reactive particles such electrons (electron beam curing) can be used.

The hardening of the resin can be done in a batch process or continuous process. In a preferred embodiment a UV light source is positioned above a metallic mould which contains the inverse of the desired relief structure. The mould is covered with a glass plate such that a cavity is created between the glass plate and the mould. Air is removed from this cavity and next the cavity if filled with a resin. Once the mould is filled with resin, a UV light source is used to harden the resin. The UV light source can be stationairy or moved over the resin filled mould to harden the resin. This movement can either continuous or stepwise. During the UV hardening, a pressure can be applied to the resin to reduce the effect of polymerization shrinkage. The complete process is carried out at a temperature below 60 °C, although polymerization heat might temporarily increase the temperature of the resin upon curing.

To create the texture into the resin, it is necessary to have a mould containing the inverse of the desired relief texture. The mold can be made of any material. Examples of materials are polymeric (e.g. poly(ethylene), poly(propylene), poly(etheretherketone) or metallic (e.g. iron, nickel, steel or copper) or ceramic (e.g. glass or porcelain).

The mould should be closed to create a mould cavity from which air can be removed and resin can be inserted. This cavity can have any size and does not necessarily have the same size as the area which is filled with resin.

In an alternative embodiment the mould is closed with a transparent substrate to which, after hardening of the resin, the relief textured cover plate is directly applied. The transparent substrate on which the resin, can be applied can be polymeric or glass. For example the glass plate can be used to cover the mould and create a mould cavity which can be filled with resin. After hardening of the resin, the glass plate including the relief textured cover plate is removed from the mould. In this case the resin itself might be an adhesive preferably with additives in the resin to promote adhesion (e.g. acid, amide, silanol, alcohol groups) or an adhesion promoter such as a thin coating of silanes which is applied to the surface of the transparent substrate prior to applying the liquid resin. Such an adhesive should have a refractive index between 1.3 and 1.7. The refractive index should be determined with an Abbe refractometer. The thickness of the transparent substrate is preferably less than 10 cm, more preferably less than 1 cm most preferably less than 5 mm. In this alternative embodiment the resin might also be textured and hardened while applied as a layer on top of the transparent substrate.

Air is removed from the mould cavity by using a vacuum. To avoid bubble formation in the product, it is important that the vacuum does not exceed the vapor pressure of the resin. The vacuum is therefore preferably between 10-30 mbar.

The process according to the invention is preferably carried out at temperatures below 100°C, more preferably at temperature below 75°C and most preferably at temperatures below 50°C. It is possible that heat originating from the curing/hardening of the resin (i.e. polymerization heat and/or radiation heat from the electromagnetic radiation source) temporarily elevates the temperature above these preferred values.

The invention pertains to a photovoltaic device containing a textured plate obtained by a method according to the invention.

To elucidate, but not to limit the invention, examples are given in the following:

### Example 1:

A resin consisting of 30% of a hexa functional aliphatic urethane acrylate, 30% of difunctional aliphatic urethane acrylate, 35%, hexanediol diacrylate (HDDA) and 5% of Triphenylphosphine oxide (TPO) is used. The resin is injected into a closed nickel mold (33 x 33 x 0.15 cm) containing an array of square based pyramid structures with a height of 1 mm. The resin is hardened for 20 seconds by an Omnicure S2000 UV light source (EXFO) having an intensity of 200 mW / cm² between λ = 320-390 nm. After the resin is hardened the mould is opened and a textured plate is obtained. A total of four of the textured plates are applied to a glass plate (substrate) of 1 x 1 meter by using liquid adhesive. The glass plate containing the textures plates is used as a further cover plate for a photovoltaic device.

### Example 2:

A resin consisting of 30% of a hexa functional aliphatic urethane acrylate, 30% of difunctional aliphatic urethane acrylate, 35%, hexanediol diacrylate (HDDA) and 5% of Triphenylphosphine oxide (TPO) is used. The resin is applied as a 0.7 mm thick layer to a glass substrate with a thickness of 3 mm. The glass plate contains an silane based adhesion promoter. A nickel mold containing an array of square based pyramid structures with a height of 1 mm is pressed into the resin layer. The resin is hardened for 20 seconds by an Omnicure S2000 UV light source (EXFO) having an intensity of 200 mW / cm² between λ = 320-390 nm. After the resin is hardened the mold is released from the glass substrate. In this case the resin is used as an appropriate adhesive between the textured plate and the transparent substrate, whereby the textured plate is made of the resin. The obtained transparent plate is used as a transparent cover plate of a solar panel.

### Example 3:

A method described in example 1 or 2 in which the resin consists of 60% of trifunctional aliphatic urethane acrylate, 30% of hexanediol diacrylate (HDDA), 5% of Si02 nanoparticles, 3% of Irgacure 819 and 2% of Tinuvin 400.

### Example 4:

A method described in example 2 in which the resin consists of 55% of trifunctional aliphatic urethane acrylate, 30% of hexanediol diacrylate (HDDA), 5% of Si02 nanoparticles, 5% of Irgacure 819, 3% of Tinuvin 400 and 2% of Tinuvin 123.

### Example 5:

A method described in example 2 in which the resin consists of 30% of hexafunctional aliphatic urethane acrylate, 30% of difunctional aliphatic urethane acrylate, 30% of hexanediol diacrylate (HDDA), 5% of Irgacure 819, 3% of Tinuvin 400 and 2% of Tinuvin 123.

### Example 6:

A method described in example 2 in which the resin consists of 30% of hexafunctional aliphatic urethane acrylate, 30% of difunctional aliphatic urethane acrylate, 30% of hexanediol diacrylate (HDDA), 4.9% of Irgacure 819, 3% of Tinuvin 400, 2% of Tinuvin 123 and 0.1 % of photoluminescent dye.

## Claims

1. A method for producing a cover plate for a photovoltaic device, which exhibits at least one surface relief texture, and comprising the following steps:
a. air is evacuated from a mould cavity by using a vacuum; the mould contains an inverse image of the surface relief texture and the mould cavity is created by closing the mould
b. bringing a resin, which is a liquid material at room temperature, by using a pressure into contact with the mould
c. hardening said resin, such that the relief texture of the mould is transferred into the hardened resin.

2. A method according to claim 1 whereby the hardening occurs while maintaining a pressure between the resin and the mould.

3. A method according to claim 1 or 2, whereby the at least one surface relief texture is made of structures, whereby each structure has a height of at least 0.5 mm.

4. A method according to any foregoing claims in which the resin is hardened by electromagnetic radiation.

5. A method according to claim 4 in which the electromagnetic radiation is in the wavelength range of 200 nm to 400 nm

6. A method according to any foregoing claims in which a resin with a viscosity at room temperature between 500-3000 Pa - s is used.

7. A method according to any foregoing claims in which the resin is applied to a transparent substrate.

8. A method according to any of the foregoing claims in which a mold with an inverse structure of pyramids and/or grooves and/or hemispheres and/or cubicals is used.

9. A method according to any of the foregoing claims in which the structures in the mold have a height of at least 0.75 mm.

10. A method according to any of the foregoing claims in which a resin with a mixture of monomer(s) and/or oligomer(s) is used.

11. A method according to any of the foregoing claims in which a resin with photoinitiator and/or at least one additive is used.

12. A method according to any of the foregoing claims in which the textured plate is coated with an additional layer after hardening the textured plate.

## Patentansprüche

1. Verfahren zum Herstellen einer Abdeckplatte für eine Fotovoltaikeinheit, die mindestens eine Oberflächenreliefstruktur aufweist, wobei das Verfahren die folgenden Schritte umfasst:
a. Absaugen von Luft aus dem Hohlraum einer Gussform durch Anlegen eines Unterdrucks; die Gussform enthält ein negatives Abbild der Oberflächenreliefstruktur und der Hohlraum der Gussform wird durch Schließen der Gussform erzeugt
b. ein Kunstharz, das bei Raumtemperatur ein flüssiges Material ist, in Kontakt mit der Gussform bringen
c. Aushärten des Kunstharzes derart, dass die Reliefstruktur der Gussform auf das ausgehärtete Kunstharz übertragen wird.

2. Verfahren nach Anspruch 1, wobei das Aushärten erfolgt, während ein Druck zwischen dem Kunstharz und der Gussform aufrechterhalten wird.

3. Verfahren nach Anspruch 1 oder 2, wobei die mindestens eine Oberflächenreliefstruktur aus Strukturen besteht, wobei jede Struktur eine Höhe von mindestens 0,5 mm aufweist.

4. Verfahren nach einem der vorhergehenden Ansprüche, wobei das Kunstharz durch elektromagnetische Strahlung ausgehärtet wird.

5. Verfahren nach Anspruch 4, wobei die elektromagnetische Strahlung im Wellenlängenbereich von 200 nm bis 400 nm liegt.

6. Verfahren nach einem der vorhergehenden Ansprüche, wobei ein Kunstharz mit einer Viskosität bei Raumtemperatur zwischen 500 und 3.000 Pa·s verwendet wird.

7. Verfahren nach einem der vorhergehenden Ansprüche, wobei das Kunstharz auf ein transparentes Substrat aufgebracht wird.

8. Verfahren nach einem der vorhergehenden Ansprüche, wobei eine Gussform mit einer inversen Struktur von Pyramiden und/oder Rillen und/oder Halbkugeln und/oder Würfelelementen verwendet wird.

9. Verfahren nach einem der vorhergehenden Ansprüche, wobei die Strukturen in der Gussform eine Höhe von mindestens 0,75 mm aufweisen.

10. Verfahren nach einem der vorhergehenden Ansprüche, wobei ein Kunstharz mit einem Gemisch von Monomer(en) und/oder Oligomer(en) verwendet wird.

11. Verfahren nach einem der vorhergehenden Ansprüche, wobei ein Kunstharz mit einem Fotoinitiator und/oder mindestens einem Additiv verwendet wird.

12. Verfahren nach einem der vorhergehenden Ansprüche, wobei die texturierte Platte nach dem Aushärten mit einer zusätzlichen Schicht beschichtet wird.

## Revendications

1. Procédé de fabrication d'une plaque de couverture pour dispositif photovoltaïque, qui présente au moins une texture de surface en relief, et qui comprend les étapes suivantes :
a) l'air est évacué d'une cavité de moulage en utilisant un appareil à vide, le moule présente une image inverse de la texture de surface en relief et la cavité du moule se trouve créée par la fermeture du moule,
b) une résine qui est un matériau liquide à température ambiante, est amenée en utilisant une pression en contact avec le moule,
c) ladite résine est durcie, de telle manière que la texture en relief du moule est transférée à la résine durcie.

2. Procédé selon la revendication 1 dans lequel le durcissement se produit pendant que la pression est maintenue entre la résine et le moule.

3. Procédé selon la revendication 1 ou 2 dans lequel au moins une texture de surface en relief est constituée de structures, chaque structure ayant une hauteur d'au moins 0,5 mm.

4. Procédé selon l'une quelconque des revendications qui précèdent dans lequel la résine est durcie au moyen d'un rayonnement électromagnétique.

5. Procédé selon la revendication 4 dans lequel le rayonnement électromagnétique se situe dans une gamme de longueurs d'onde comprise entre 200 nm et 400 nm.

6. Procédé selon l'une quelconque des revendications qui précèdent dans lequel on utilise une résine dont la viscosité à température ambiante est comprise entre 500 et 3000 Pa.

7. Procédé selon l'une quelconque des revendications qui précèdent dans lequel la résine est appliquée sur un substrat transparent.

8. Procédé selon l'une quelconque des revendications qui précèdent dans lequel on utilise un moule comportant une structure inversée constituée de pyramides et/ou de gorges et/ou d'hémisphères et/ou de formes cubiques.

9. Procédé selon l'une quelconque des revendications qui précèdent dans lequel les structures du moule ont une hauteur d'au moins 0,75 mm.

10. Procédé selon l'une quelconque des revendications qui précèdent dans lequel on utilise une résine constituée d'un mélange de monomère(s) et/ou d'oligomère(s).

11. Procédé selon l'une quelconque des revendications qui précèdent dans lequel on utilise une résine comportant un photocatalyseur et/ou au moins un additif.

12. Procédé selon l'une quelconque des revendications qui précèdent dans lequel la plaque texturée est revêtue d'une couche supplémentaire après son durcissement.
